# EUROPÄISCHE PATENTANMELDUNG

(11) **EP 1 555 333 A2**
(43) Veröffentlichungstag der Anmeldung: **20.07.2005**
(21) Anmeldenummer: 05004367.8
(22) Anmeldetag: 10.04.2002
(51) Int. Cl.: C23C 14/08

(54) **Wärmedämmschichtsystem**

(62) Teilanmeldung aus: 02008046.1
(71) Anmelder: SIEMENS AKTIENGESELLSCHAFT, 80333 München (DE)
(72) Erfinder: Bast, Ulrich, Dr., 81667 München (DE); Greil, Peter, Prof., 91085 Weisendorf (DE); Müller, Frank, 81207 Lauf (DE)

(57) **Zusammenfassung**

Wärmedämmschichtsysteme nach dem Stand der Technik sind mechanischen Belastungen ausgesetzt, wobei insbesondere keramische Schichten aufgrund ihrer Sprödheit zur Rissbildung oder zum Abplatzen neigen.

Ein erfindungsgemäßes Wärmedämmschichtsystem (19) weist eine Zweitphase (34) auf, die die Matrix (31) der Schicht (25, 28) mechanisch verstärkt.

## Beschreibung

Die Erfindung betrifft ein Wärmedammschichtsystem, das aus einem Substrat und darauf aufliegenden Schichten besteht und ein Verfahren zum Herstellen dieser.

Aus der EP 1 029 101 B1 ist eine Wärmedämmschicht bekannt, wobei die keramische äußere Schicht die Materialzusammensetzung La-Al-Gd-O oder Sr-Ca-Zr-O aufweist.

Die US 5,545,484 weist ein Schichtsystem auf, bei dem das Substrat durch Fasern mechanisch verstärkt ist.

Die JP 56156754 offenbart ein Verfahren zur Herstellung einer metallischen Schicht, bei der zwei Düsen verwendet werden und dass ein nicht-metallisches Zweitphasenmaterial dem Plasmastrahl an der Stelle zugeführt wird, an der eine niedrige Temperatur herrscht.

Die US 4,814,575 offenbart ein Verfahren zum Beschichten eines keramischen Werkstücks, bei dem keramisches Material auf einer Oberfläche mit Mikrorissen aufgetragen wird.

Die Wärmedämmschichten sind im wesentlichen Funktionsschichten und sollen das Substrat beispielsweise vor zu großer Wärme schützen. Das Substrat weist eine hinreichend große mechanische Festigkeit auf. Die Wärmedämmschichten sind ebenfalls thermischen Spannungen oder mechanischen Spannungen ausgesetzt und können durch Abplatzen versagen, weil Risse entstehen.

Es ist daher Aufgabe der Erfindung ein Wärmedämmschichtsystem und Verfahren zum Herstellen dieser aufzuzeigen, bei dem die Schichten thermischen und mechanischen Spannungen besser standhalten können.

Die Aufgabe wird durch ein Wärmedämmschichtsystem gemäß Anspruch 1 gelöst. Dabei wird in die zumindest eine Schicht eine Zweitphase eingebracht, die die Schicht in ihren mechanischen Eigenschaften verbessert.

In den Unteransprüchen 2 bis 17 sind weitere vorteilhafte Verbesserungen des Wärmedämmschichtsystems aufgelistet, wodurch die mechanische Festigkeit (Biege-, Druck-,..) und Bruchzähigkeit (K_{1c}) verbessert wird.

Die Zweitphase kann in Form von Fasern oder Partikeln vorhanden sein. Als Fasern kommen herkömmliche Kohlestofffasern oder Fasern aus anderem Material bzw. Whisker in Frage.

Die Partikel, die die Zweitphase bilden, können die gleichen Elemente wie das Matrixmaterial der Schicht aufweisen oder aber auch aus einem anderen Materialsystem gewählt sein.

Wenn die Partikel länglich sind, d.h. ein hohes Verhältnis von Länge zu Querschnittsfläche aufweisen (großes aspectratio) wird die Schicht bzw. das Matrixmaterial der Schicht, durch Rissumlenkung und/oder Rissverzweigung vorteilhaft verstärkt.

Als zu verstärkende Schicht kann eine keramische oder metallische Schicht, der auf dem Substrat aufliegenden Schichten gewählt werden. Insbesondere ist dies die Wärmedämmschicht.

Die Aufgabe zum Herstellen eines durch eine Zweitphase verstärkten Wärmedämmschichtsystems wird durch ein Verfahren gemäß Anspruch 18 gelöst.

Das Matrixmaterial der Schicht wird durch bekannte Beschichtungsverfahren wie Plasmaspritzen, CVD (chemical vapour deposition) oder PVD (physical vapour deposition) aufgebracht, wobei die Zweitphase über eine separate Quelle in das Matrixmaterial der Schicht eingebracht wird.

Ausführungsbeispiele sind in den nachfolgenden Figuren gezeigt.

Es zeiqen:
- Figur 1: eine Turbinenschaufel,
- Figur 2: ein Wärmedämmschichtsystem,
- Figur 3: eine schematische Darstellung der Mikrostruktur einer Schicht des erfindungsgemäßen Wärmedämmschichtschichtsystems und
- Figur 4: schematisch eine Beschichtungsvorrichtung, um die erfindungsgemäßen Verfahren durchführen zu können, und
- Figuren 5, 6: weitere Ausführungsbeispiele der erfindungsgemäßen Wärmedämmschicht.

Gleiche Bezugszeichen haben in den verschiedenen Figuren die gleiche Bedeutung.

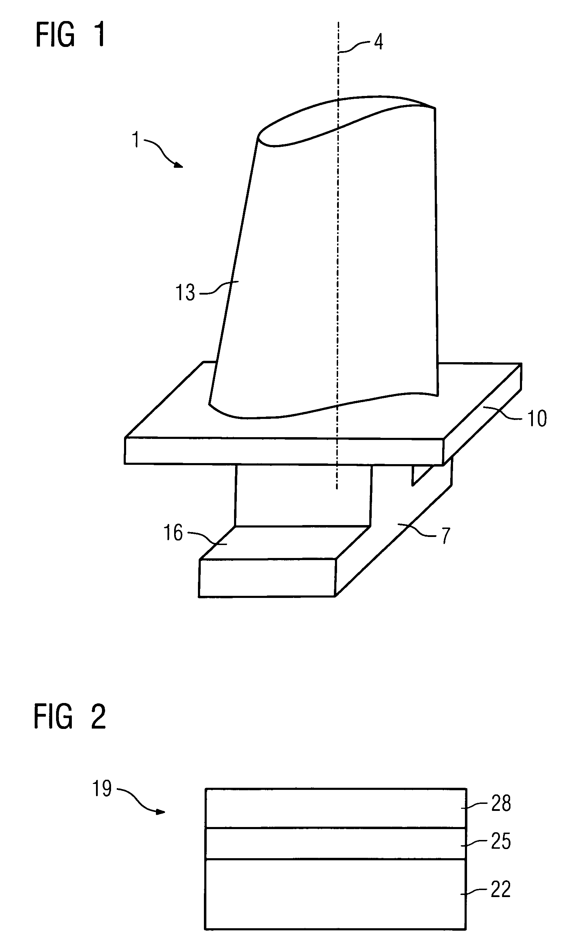

Figur 1 zeigt in perspektivischer Ansicht eine Laufschaufel 1, die sich entlang einer Längsachse 4 erstreckt.
Die Laufschaufel 1 weist entlang der Längsachse 4 aufeinander folgend einen Befestigungsbereich 7, eine daran angrenzende Schaufelplattform 10 sowie einen Schaufelblattbereich 13 auf.

Im Befestigungsbereich 7 ist ein Schaufelfuß 16 gebildet, der zur Befestigung der Laufschaufel 1 an einer nicht dargestellten Welle einer ebenfalls nicht dargestellten Strömungomaschine dient. Der Schaufelfuß 16 ist beispielsweise als Hammerkopf ausgestaltet. Andere Ausgestaltungen sind möglich.
Bei herkömmlichen Laufschaufeln werden in allen Bereichen 7, 10, 13 und 16 massive metallische Werkstoffe verwendet. Die Laufschaufel 1 kann hierbei durch ein Gussverfahren, durch ein Schmiedeverfahren, durch ein Fräsverfahren oder Kombinationen daraus gefertigt sein.
Insbesondere im Schaufelblattbereich 13, der höheren Temperaturen beispielsweise einer Gasturbine ausgesetzt ist, ist zumindest eine Schicht, insbesondere eine Oxidations/Korrosionsschutzschicht und Wärmedämmschicht, aufgebracht, die Teil eines Wärmedämmschichtsystems ist.

Figur 2 zeigt ein solches erfindungsgemäßes Wärmedämmschichtsystem 19.
Das Wärmedämmschichtsystem 19 weist ein Substrat 22 auf, beispielsweise eine Nickel- oder Kobalt- basierte Superlegierung auf der beispielsweise zumindest eine Zwischenschicht 25 aufgebracht ist.

Die Zwischenschicht 25 kann aus mehreren Schichten bestehen, die beispielsweise als Diffusionsbarriere, als Haftvermittlerschicht (MCrAlY, M= Fe, Co, Ni), Korrosionsschutzschicht oder als Verankerungsschicht dienen.
Auf dem Substrat 22 oder auf der zumindest einen Zwischenschicht 25 ist beispielsweise eine keramische Wärmedämmschicht 28 aufgebracht.
Die zumindest eine Zwischenschicht 25 und die Wärmedämmschicht 28 sind mechanischen Belastungen ausgesetzt.

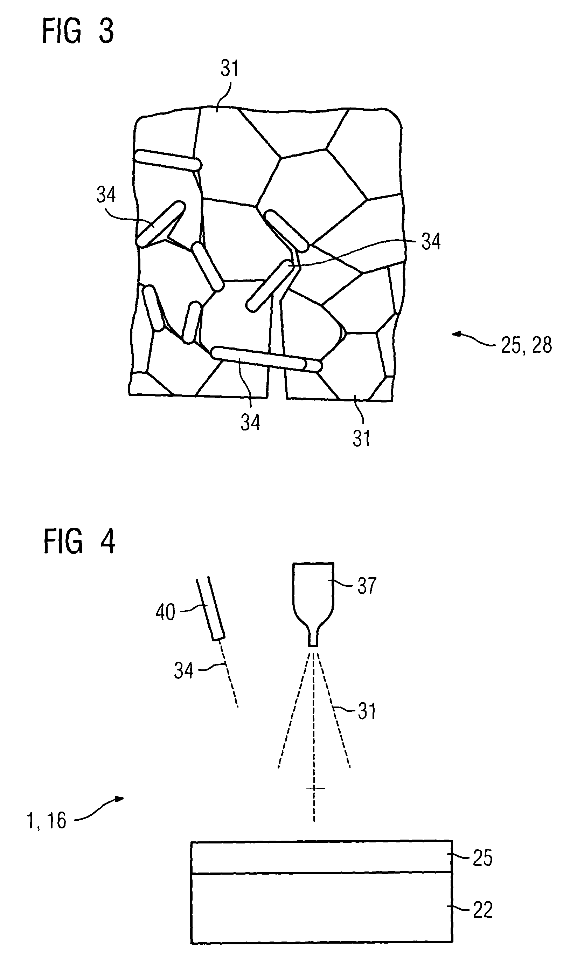

Figur 3 zeigt schematisch eine Mikrostruktur der Zwischenschicht 25 oder der Wärmedämmschicht 28.

Die erfindungsgemäße Schicht 25, 28 besteht aus einer Matrix 31 und einer Zweitphase 34. Die Matrix 31 besteht aus Körnern, die verschiedene Formen (Morphologien) aufweisen können. Wird die Matrix 31 beispielsweise durch Plasmaspritzen hergestellt, so weisen die Körner des Matrixmaterials 31 eine plättchenförmige Gestalt auf. Die Zweitphase 34 kann beim Plasmaspritzen mit dem Matrixmaterial 31 beispielsweise vermischt sein und zusammen durch eine Brennerdüse (Fig. 4) aufgetragen werden.

Die Zweitphase 34 kann eine andere Phase des Matrixmaterials 31, aber auch eine Faser oder ein Whisker sein.

Die Zweitphase 34 hat die Aufgabe die mechanische Festigkeit der Matrix 31 zu verstärken. Dies kann durch Faserverstärkung oder Partikelverstärkung mit den bekannten Verstärkungsmechanismen gewährleistet sein. Insbesondere, wenn die Zweitphase 34 eine längliche Form aufweist, wird die mechanische Festigkeit der Matrix 31 besonders erhöht.

Als Material 31 für die Wärmedämmschicht 28 kommen die in der EP 1 029 101 B1 offenbarten Materialien in Betracht, d.h. die Systeme La₁₋ₓ Gdₓ AlO₃ oder Ca₁₋ₓ Srₓ ZrO2₃. Die EP 1 029 101 B1 soll insbesondere Teil der Offenbarung der vorliegenden Anmeldung sein. Die Elemente Gd und La können durch andere Lanthanide ersetzt sein.

Als Zweitphase 34 zur Verstärkung der Matrix 31 für das Matrixmaterial 31 Gd-La-Al-O wird insbesondere die Zweitphase 34 mit der Zusammensetzung LaAl₁₁O₁₈ (β-Aluminat) verwendet.

Die Schicht 25, 28 kann durch verschiedene Beschichtungsverfahren wie z.B. Plasmaspritzen, CVD- oder PVD-Verfahren hergestellt werden.

Beim Plasmaspritzen kann die Zweitphase 34 mit dem Matrixmaterial 31 vermischt werden und durch die Brennerdüse auf das Substrat 22 oder die Zwischenschicht 25 aufgebracht werden.

Es kann jedoch bei bestimmten Zweitphasen 34 der Fall auftreten, dass die Zweitphase bei den hohen Temperaturen des Plasmaspritzens nicht phasenstabil ist. Ebenso kann es bei den CVD- oder PVD-Verfahren der Fall sein, dass mit diesem Verfahren nur eine Materialzusammensetzung, nämlich die der Matrix 31, aufgebracht werden kann. In diesem Fall wird die Zweitphase über eine separate Nebendüse 40 (Fig. 4) in die Schicht 25, 28 eingebracht.

Figur 4 zeigt schematisch eine Beschichtungsvorrichtung, mit der eine Zweitphase und ein Matrixmaterial 31 aufgebracht wird.

Mittels einer Hauptdüse 37, die beispielsweise eine Brennerdüse einer Plasmabeschichtungsanlage ist, oder eines Substrats 37 einer PVD-Anlage, wird das Matrixmaterial 31 auf das Substrat 22 oder die zumindest eine Zwischenschicht 25 aufgebracht.

Mittels einer separaten Quelle beispielsweise einer Nebendüse 40 wird die Zweitphase 34 in den Partikelstrom des Matrixmaterials 31 beigemischt, so dass sich eine Matrix 31 mit einer Zweitphase, die einen Volumenanteil kleiner 50% aufweist, bildet.

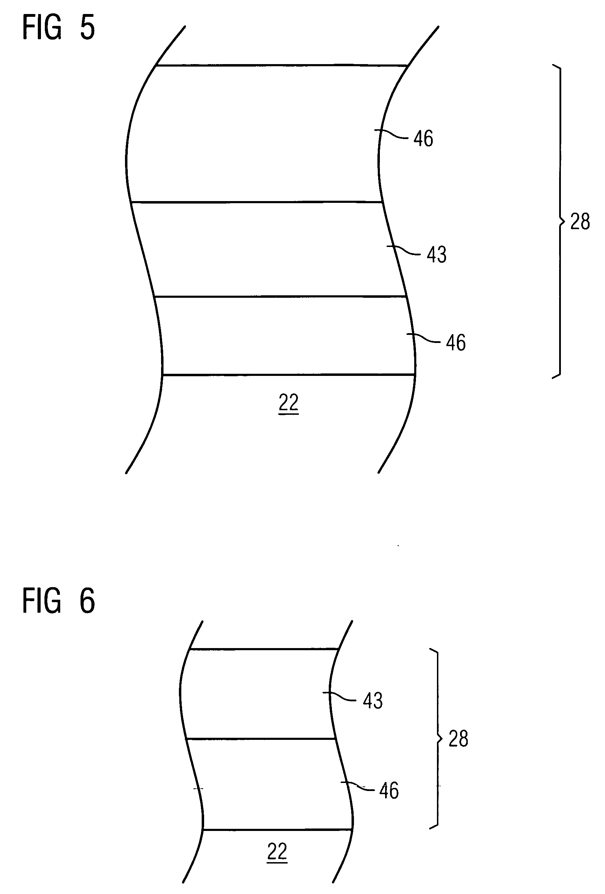

Figur 5 zeigt eine Schicht eines erfindungsgemäßen Wärmedämmschichtsystems.
Die Schicht 28 ist zumindest zweilagig und besteht aus zwei Schichten 46, die nicht verstärkt sind, und einer Schicht 43, die durch eine Zweitphase verstärkt ist.
Die erste Schicht 46 liegt beispielsweise auf dem Substrat 22 oder der Schicht 25 auf. Dann folgt die Schicht 43 und als äußere Schicht die unverstärkte Schicht 46.
Risse können nicht oder nur schwer durch die Schicht 43 hindurchwachsen, so dass ein Ablösen der Schicht 28 vom Substrat 22 verhindert wird.

Figur 6 zeigt eine Schicht eines erfindungsgemäßen Wärmedämmschichtsystems.
Die Schicht 28 ist zweilagig und besteht aus einer Schicht 46, die nicht verstärkt ist, und einer Schicht 43, die durch eine Zweitphase verstärkt ist.
Die erste Schicht 43 liegt beispielsweise auf dem Substrat 22 oder der Schicht 25 auf. Dann folgt die Schicht 43 als äußere Schicht oder umgekehrt.
Risse können nicht oder nur schwer durch die Schicht 43 hindurchwachsen, so dass ein Ablösen der Schicht 28 vom Substrat 22 verhindert wird.

## Patentansprüche

1. Wärmedämmschichtsystem,
bestehend aus
einem Substrat und
zumindest einer darauf aufliegenden Schicht,
**dadurch gekennzeichnet,**
**dass** zumindest eine mechanische Eigenschaft der zumindest einen Schicht (25, 28) durch Vorhandensein einer Zweitphase (34) in einem Matrixmaterial (31) der Schicht (25, 28) gegenüber einer Schicht,
die nur aus dem Matrixmaterial besteht,
verbessert ist,
**dass** zumindest eine Schicht (28) keramisch ist und
**dass** die Zweitphase (34) in der keramischen Schicht (28) nur lokal vorhanden ist.

2. Wärmedämmschichtsystem nach Anspruch 1,
**dadurch gekennzeichnet, dass**
die mechanische Eigenschaft die mechanische Festigkeit ist.

3. Wärmedämmschichtsystem nach Anspruch 1,
**dadurch gekennzeichnet, dass**
die mechanische Eigenschaft die Bruchzähigkeit ist.

4. Wärmedämmschichtsystem nach Anspruch 1,
**dadurch gekennzeichnet, dass**
die Zweitphase (34) eine Faser ist.

5. Wärmedämmschichtsystem nach Anspruch 1,
**dadurch gekennzeichnet, dass**
die Zweitphase (34) durch Partikel gebildet ist,
so dass eine Partikelverstärkung der Schicht (25, 28) auftritt.

6. Wärmedämmschichtsystem nach Anspruch 5,
**dadurch gekennzeichnet, dass**
die Partikel (34) eine längliche Form aufweisen.

7. Wärmedämmschichtsystem nach Anspruch 1,
**dadurch gekennzeichnet, dass**
die Schicht (25, 28) eine Wärmedämmschicht (28) ist.

8. Wärmedämmschichtsystem nach Anspruch 1 oder 7,
**dadurch gekennzeichnet, dass**
das Matrixmaterial (31) der Schicht (28) eine Zusammensetzung des systems La-Al-O aufweist.

9. Wärmedämmschichtsystem nach Anspruch 1 oder 7,
**dadurch gekennzeichnet, dass**
das Matrixmaterial (31) der Schicht (28) eine Zusammensetzung des Systems Gd-La-Al-O aufweist.

10. Wärmedämmschichtsystem nach Anspruch 1 oder 7,
**dadurch gekennzeichnet, dass**
das Matrixmaterial (31) der Schicht (28) aus dem System Sr-Ca-Zr-O gebildet ist.

11. Wärmedämmschichtsystem nach Anspruch 1,
**dadurch gekennzeichnet, dass**
die Zweitphase (34) die Zusammensetzung LaAl₁₁O₁₈ aufweist.

12. Wärmedämmschichtsystem nach Anspruch 1,
**dadurch gekennzeichnet, dass**
die Schicht (25) eine metallische Schicht,
insbesondere eine MCrAlY-Schicht (25) ist.

13. Wärmedämmschichtsystem nach Anspruch 9, 10 oder 12,
**dadurch gekennzeichnet, dass**
die Lanthan in dem Matrixmaterial oder Material der Zweitphase durch andere Lanthanide ersetzt sind.

14. Wärmedämmschichtsystem nach Anspruch 1,
**dadurch gekennzeichnet, dass**
das Wärmdämmschichtsystem (16) eine Turbinenschaufel (1) darstellt.

15. Wärmedämmschichtsystem nach Anspruch 1,
**dadurch gekennzeichnet, dass**
die Wärmedämmschicht zumindest zweilagig ist.

16. Wärmedämmschichtsystem nach Anspruch 15,
**dadurch gekennzeichnet, dass**
ein äußerer Schichtteil der Wärmedämmschicht die Zweitphase aufweist.

17. Wärmedämmschichtsystem nach Anspruch 15,
**dadurch gekennzeichnet, dass**
ein innerer Schichtteil der Wärmedämmschicht die Zweitphase aufweist.

18. Verfahren zum Herstellen eines Wärmedämmschichtsystems (19),
insbesondere nach Anspruch 1,
bei dem das keramische Matrixmaterial (31) einer keramischen Schicht (25, 28) mittels eines Beschichtungsverfahrens auf ein Substrat (22) oder eine Schicht (25) aufgebracht wird,
wobei das Material einer Zweitphase (34) über eine Nebendüse (40) in die keramische Matrix (31) eingebracht wird.

19. Verfahren nach Anspruch 18,
**dadurch gekennzeichnet, dass**
das Beschichtungsverfahren ein Plasmaspritz-Verfahren ist.

20. Verfahren nach Anspruch 18,
**dadurch gekennzeichnet, dass**
das Beschichtungsverfahren ein PVD-Verfahren ist.

21. Verfahren nach Anspruch 18,
**dadurch gekennzeichnet, dass**
das Beschichtungsverfahren ein CVD-Verfahren ist.
